# EUROPÄISCHE PATENTSCHRIFT

(11) **EP 0 632 079 B1**
(45) Veröffentlichungstag und Bekanntmachung des Hinweises auf die Patenterteilung: **19.07.2000**
(21) Anmeldenummer: 94810376.7
(22) Anmeldetag: 23.06.1994
(51) Int. Cl.: C08G 59/14, C08G 59/42, C08F 290/14, C08G 59/32, C08G 59/06

(54) **Epoxyacrylate**
Epoxyacrylates
Résines époxyacrylates

(30) Priorität: 02.07.1993 CH 200493
(43) Veröffentlichungstag der Anmeldung: 04.01.1995
(73) Patentinhaber: Ciba Specialty Chemicals Holding Inc., 4057 Basel (CH)
(72) Erfinder: Roth, Martin, Dr., CH-1735 Giffers (CH); Salvin, Roger, Dr., D-79576 Weil am Rhein (DE); Meier, Kurt, Dr., CH-4106 Therwil (CH); Sailer, Bernhard, Dr., CH-4058 Basel (CH); Wiesendanger, Rolf, Dr., CH-4125 Riehen (CH)

(56) Entgegenhaltungen:
- EP-A- 0 418 011
- WO-A-89/07785
- GB-A- 1 187 652
- GB-A- 2 253 629

## Beschreibung

Die Erfindung betrifft neue höhermolekulare Epoxyacrylate sowie neue höhermolekulare carboxylgruppenhaltige Epoxyacrylate, Verfahren zu deren Herstellung, die Verwendung dieser Acrylate in Photoresistformulierungen und die Anwendung dieser Formulierungen vor allem auf dem Gebiet der Leiterplatten und der Druckplatten.

Epoxyacrylate sind in grosser Zahl bekannt und werden unter anderem auch in Zusammensetzungen verwendet, die als Photoresistformulierungen dienen, so z.B. in GB 2 175 908, wo Harze aus einem ungesättigten polybasischen Säureanhydrid auf einem Reaktionsprodukt eines Epoxynovolaken und einer ungesättigten Monocarbonsäure verwendet werden.

Desweiteren beschreibt z.B. die EP 0,273,729 Zusammensetzungen für Lötstoppresists, die Umsetzungsprodukte aus Epoxynovolakharzen mit Acrylsäure und mehrbasischen Carbonsäureanhydriden enthalten. Sie sind wässrig-alkalisch entwickelbar und weisen eine gute Wärmebeständigkeit und Photoempfindlichkeit auf. Allerdings lässt die Chemikalienbeständigkeit noch zu wünschen übrig.

Die EP 0,418,011 offenbart Zusammensetzungen für Lötstoppresists, ebenfalls basierend auf Reaktionsprodukten von Epoxykresolnovolaken mit Acrylsäure und cyclischen Dicarbonsäureanhydriden, wobei 0,4 bis 0,9 Aequivalente Acrylsäure pro Aequivalent Epoxy-gruppe eingesetzt werden, so dass das Endprodukt zugleich Säure- und Epoxygruppen im gleichen Molekül aufweist. Dadurch wird in der Applikation eine zweite thermische Vernetzungsreaktion zwischen diesen beiden Funktionalitäten ermöglicht. Problematisch ist hier neben der Herstellung der Produkte (Gefahr der Gelierung bei der Reaktion mit dem Anhydrid) auch die Lagerstabilität, da bereits bei Raumtemperatur eine bestimmte Reaktivität der derartige Umsetzungsprodukte enthaltenden Formulierung vorhanden ist.

Generell sind all diese genannten Epoxyacrylate relativ niedermolekular.

Photochemisch oder thermisch gehärtete Epoxyacrylate, die sich von niedermolekularen Epoxyharzen und Epoxynovolaken ableiten, sind zwar für ihre guten thermischen und mechanischen Eigenschaften sowie ihre gute chemische Beständigkeit gegen agressive Chemikalien bekannt. Allerdings lassen die Klebrigkeit und die Kantendeckung der mit diesen Systemen erhaltenen Resistfilme auf Leiterzügen wegen der relativ niedrigen Molekularmasse zu wünschen übrig. Man ist deshalb in der Technik vielfach gezwungen, diese Nachteile durch den Zusatz von hochmolekularen Binderpolymeren zu umgehen. Diese weisen normalerweise keine funktionellen Acrylatgruppen auf und reagieren bei der photochemischen oder thermischen Härtung nicht mit, d.h. sie werden als "passive" Bestandteile im Netzwerk nicht eingebaut und führen somit zu einer Verdünnung der Netzwerkdichte. Dies hat wieder eine ungünstige Beeinflussung speziell der chemischen Beständigkeit und der elektrischen Eigenschaften von prozessierten Resistschichten zur Folge. Ausserdem sinkt die Photoempfindlichkeit infolge der "Verdünnung" der Acrylatgruppen. Durch die Verwendung von hochmolekularen Binderpolymeren weisen diese Zusammensetzungen bereits bei relativ niedrigem Festkörpergehalt eine hohe Viskosität auf und führen daher oft zu grossen an wendungstechnischen Problemen bei der Beschichtung.

In der japanischen Patentanmeldung Kokai Hei 04-294352 werden Epoxynovolakharze durch Umsetzung mit einer ungesättigten Monocarbonsäure und anschliessend mit einem ungesättigtem Anhydrid einer Polycarbonsäure modifiziert und in photoempfindlichen wässrigen Zusammensetzungen eingesetzt.

Gemäss dem englischen Patent Nr. 1187652 werden photoempfindliche polymerisierbare Systeme zur Herstellung von Leiterplatten vorgeschlagen, indem ein mit Resorcin verlängertes und vollständig methacryliertes Epoxyphenolnovolack eingesetzt wird.

In der PCT-Patentanmeldung Nr. WO 89/07785 werden photopolymerisierbare Beschichtungssysteme vorgeschlagen, welche Epoxyacrylate enthalten, die mit einem Carbonsäureanhydrid weitermodifiziert werden.

Aufgabe der vorliegenden Erfindung war es daher, neue Acrylate für den Einsatz in Resistformulierungen zu entwickeln, die die aufgezeigten Nachteile nicht aufweisen.

Erfindungsgemäss wird diese Aufgabe durch neue Epoxyacrylate und neue carboxylgruppenhaltige Epoxyacrylate gelöst, die höhermolekular sind und bei Verwendung in Resistformulierungen ohne oder nur mit geringen Mengen (< 10 Gew.%) von zusätzlichen Binderpolymeren auskommen. Sie werden durch Umsetzung von sogenannten "avancierten" Epoxynovolaken mit z.B. (Meth)acrylsäure erhalten.

Erfindungsgemäss entsprechen die neuen Epoxyacrylate der Formel II 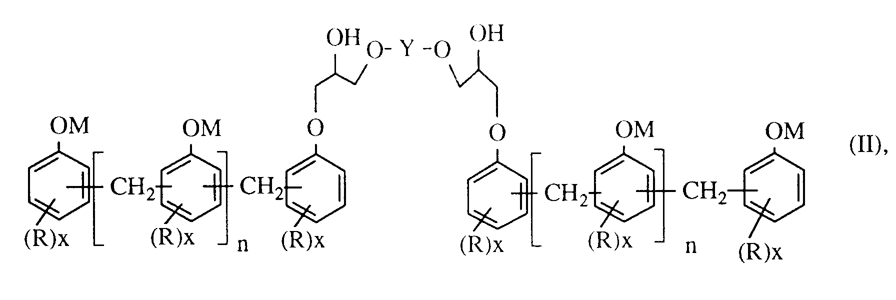 worin
- M: die Gruppe der Formeln 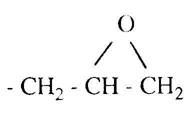 oder 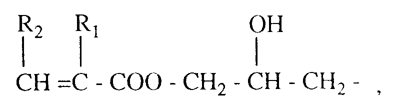
- R₁: -H oder -CH₃, R₂ -H, -CH₃ oder Phenyl,
- R: C₁-C₄ Alkyl oder Halogen, vorzugsweise CH₃ oder Br,
- x: eine ganze Zahl von 0 bis 3, vorzugsweise 0 oder 1, und
- Y: ein Brückenglied der Formeln 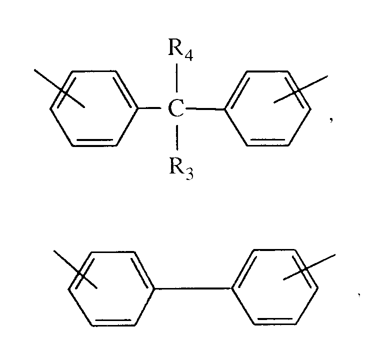 oder 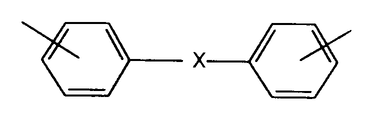 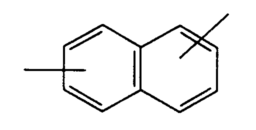 bedeuten,
worin R₃ und R₄ unabhängig voneinander Wasserstoff oder C₁-C₄ Alkyl bedeuten oder R₃ und R₄ zusammen mit dem C-Atom, an dem sie gebunden sind, einen 5-oder 6-gliedrigen Kohlenwasserstoff-Ring bilden, und die aromatischen Reste des Brückengliedes Y unsubstituiert oder durch Halogen oder C₁-C₄ Alkyl substituiert sind,
- X: -S-, -O-, oder -SO₂-, und
- n: eine ganze Zahl von 0 bis 300, insbesondere von 0 bis 30 bedeuten,
wobei mindestens 10 Mol % der Reste M die Struktur der Formel 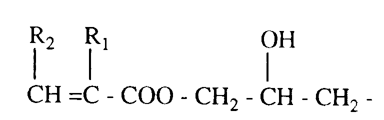 aufweisen, wobei R₁ und R₂ die oben angegebene Bedeutung haben.

Sind die aromatischen Reste des Brückengliedes Y substituiert, so kommen als Halogen, Fluor, Chlor und besonders Brom, und als C₁-C₄ Alkyl geradkettige oder verzweigte C₁-C₄ Alkylgruppen, wie Methyl, Ethyl, n- und iso-Propyl, n-, sek.- und tert.-Butyl, in Frage.

Besonders bevorzugte Brückenglieder Y entsprechen der Formel 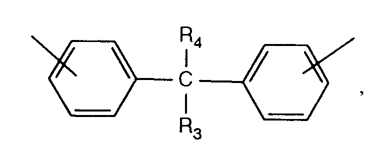 worin R₃ und R₄ die oben angegebene Bedeutung haben, und vor allem den Formeln

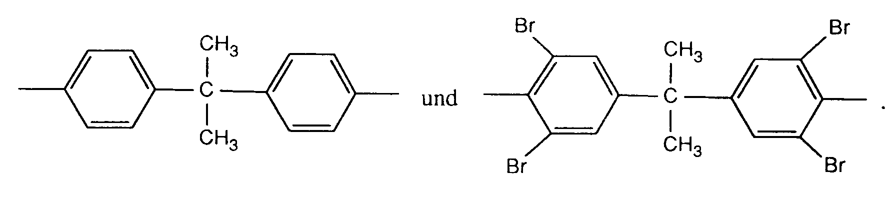

Bevorzugte Epoxyacrylate weisen die Formel II auf, worin R -H (bei x=0) oder -CH₃, R₁ -H oder -CH₃, R₂-H, x die Zahl 0 oder 1, n eine ganze Zahl von 0 bis 30 und Y ein Brückenglied der Formel 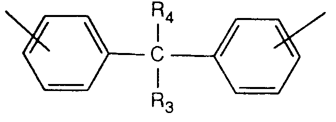 sind, worin R₃ und R₄ -H oder C₁-C₄ Alkyl und die aromatischen Reste des Brückengliedes unsubstituiert oder durch Halogen oder C₁-C₄ Alkyl substituiert sind.

Diese neuen Epoxyacrylate der Formel II können erhalten werden, indem ein avancierter Epoxynovolak der Formel I 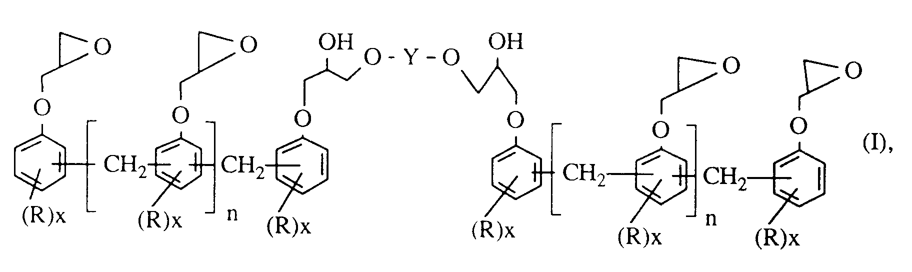 worin R, Y, n und x die oben unter Formel II angegebene Bedeutung haben, mit einer ethylenisch ungesättigten Monocarbonsäure gegebenenfalls in Anwesenheit eines Katalysators und eines Polymerisationsinhibitors bei erhöhter Temperatur umgesetzt wird.

Die avancierten Epoxynovolake der Formel I sind bekannt (siehe z.B. die Jap. Patentanmeldung Hei 1-195056) und werden aus einem Bisphenol der Formel HO-Y-OH, worin Y die oben angegebene Bedeutung haben, und einem Epoxynovolak nach bekannter Art und Weise hergestellt, wobei die molare Menge vom Bisphenol zweckmässig 0,01 bis 0,1 Mol pro Epoxygruppe im Epoxynovolak beträgt.

Diese avancierten Epoxynovolake der Formel I weisen sekundäre, aliphatische Hydroxylgruppen auf.

Die Umsetzung der avancierten Epoxynovolake der Formel I zu den neuen Epoxyacrylaten der Formel II erfolgt nach bekannter Art und Weise, z.B. durch Reaktion mit einer ethylenisch ungesättigten Monocarbonsäure der Formel 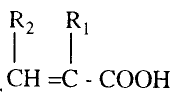 Es kommen Crotonsäure, Zimtsäure, und vor allem Acrylsäure oder Methacrylsäure oder deren Mischungen in Betracht. R₁ und R₂ haben die oben angegebene Bedeutung.

Bei dieser Reaktion wird bevorzugt ein Katalysator eingesetzt. Als Katalysatoren kommen vor allem Metallsalze, wie Chromverbindungen, Amine, wie Triethylamin oder Benzyldimethylamin, Ammoniumsalze, wie z.B. Benzyltrimethylammoniumchlorid, oder auch Triphenylphosphin und Triphenylwismuth, in Frage.

Gegebenenfalls wird der Reaktion ein Lösungsmittel zugefügt, da die avancierten Epoxynovolake der Formel I als Feststoffe vorliegen. Das Lösungsmittel muss gegenüber dem Edukt inert sein. Als Lösungsmittel kommen z.B. in Frage: Ketone, wie Aceton, Methylethylketon, Cyclohexanon; Ester, wie Essigsäureethyl- und -butylester, Ethoxyethylacetat und Methoxypropylacetat; Ether, wie Dimethoxyethan und Dioxan; aromatische Kohlenwasserstoffe, wie Toluol, Benzol und Xylole, sowie Gemische zweier oder mehrerer dieser genannten Lösungsmittel.

Die Temperatur variiert zweckmässig zwischen etwa 80 und 140°C, wobei für die Reaktion mit Acrylsäure bevorzugt bei 80 bis 120°C und für die Reaktion mit Methacrylsäure bevorzugt bei 80 bis 140°C gearbeitet wird.

Gegebenenfalls kann dem Reaktionsmedium auch ein Polymerisationsinhibitor zugesetzt werden; als solche kommen z.B. in Frage: Hydrochinon, Hydrochinonmonomethylether und 2,6-Di-tert.-butyl-p-kresol.

Es ist zweckmässig, in das Reaktionsmedium Luft oder ein Gemisch aus Stickstoff/Sauerstoff einzuleiten, da einige der oben genannten Polymerisationsinhibitoren nur in Anwesenheit von Sauerstoff wirksam sind. In Abhängigkeit von der eingesetzten Menge der ethylenisch ungesättigten Monocarbonsäure werden Epoxyacrylate der Formel II erhalten, die vollständig oder nur teilweise acryliert sind. Dabei kann die Monocarbonsäure in aequimolaren Mengen bezüglich der Epoxygruppen oder im Unterschuss eingesetzt werden. Die vollständig umgesetzten Epoxyacrylate enthalten praktisch keine Epoxygruppen mehr.

Die erfindungsgemässen Epoxyacrylate der Formel II müssen in der Regel weder aus dem Reaktionsmedium isoliert noch gereinigt werden. Die Reaktionslösung kann als solche verwendet werden.

Sowohl die teilweise als auch die vollständig umgesetzten Produkte der Formel II enthalten aliphatische Hydroxylgruppen, die aus der Reaktion der Epoxygruppen mit der ethylenisch ungesättigten Monocarbonsäure herrühren. Zusätzlich können noch aliphatische Hydroxylgruppen aus dem Edukt vorhanden sein.

Die vollständig acrylierten Epoxyacrylate der Formel IIa können dann weiter zu carboxylgruppenhaltigen Epoxyacrylaten der Formel III umgesetzt werden:
Formel IIa: 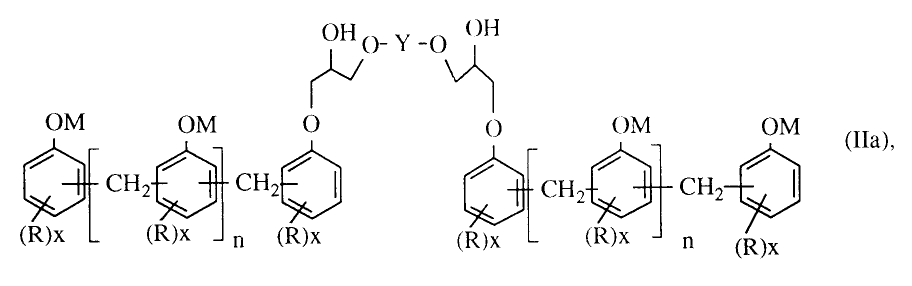 worin
- M: die Gruppe der Formel 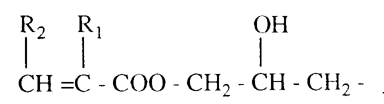
- R₁: -H oder -CH₃, R₂ -H, -CH₃ oder Phenyl,
- R: C₁-C₄ Alkyl oder Halogen, vorzugsweise CH₃ oder Br,
- x: eine ganze Zahl von 0 bis 3, vorzugsweise 0 oder 1, und
- Y: ein Brückenglied der Formeln 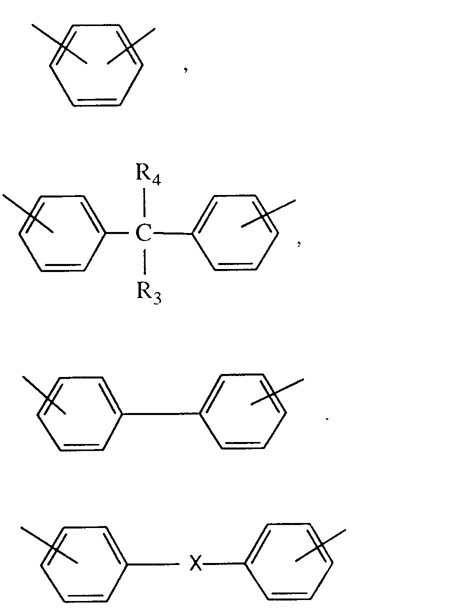 oder 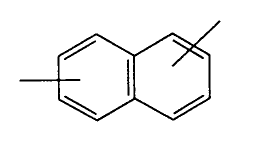 bedeuten, worin R₃ und R₄ unabhängig voneinander Wasserstoff oder C₁-C₄ Alkyl bedeuten oder R₃ und R₄ zusammen mit dem C-Atom, an dem sie gebunden sind, einen 5- oder 6-gliedrigen Kohlenwasserstoff-Ring bilden, und die aromatischen Reste des Brückengliedes Y unsubstituiert oder durch Halogen oder C₁-C₄ Alkyl substituiert sind,
- X: -S-, -O-, oder -SO₂-, und
- n: eine ganze Zahl von 0 bis 300, insbesondere von 0 bis 30 bedeuten,
Formel III: 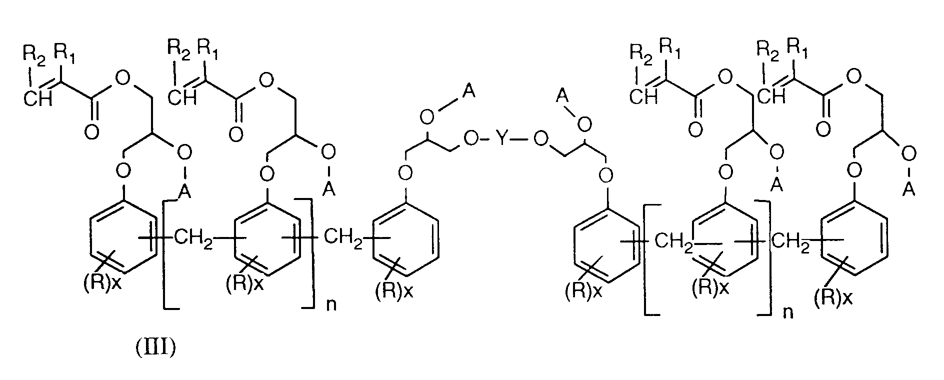 worin
- A: Wasserstoff oder die Gruppe der Formel 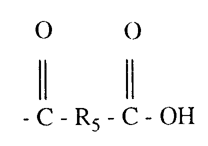 bedeutet, und
R₁, R₂, R, n, x und Y die oben unter Formel IIa angegebene Bedeutung haben und R₅ den Rest eines cyclischen Anhydrides einer Polycarbonsäure nach Entfernen des Anhydridrestes darstellt, und wobei mindestens 10 Mol % der Reste A die Struktur der Formel 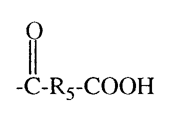 aufweisen.

Bevorzugte Epoxyacrylate der Formel III entsprechen den bevorzugten Epoxyacrylaten der oben angegebenen Formel II bzw. IIa, und die Reste R₁, R₂, R, x, n und Y in der Formel III haben die gleichen bevorzugten Bedeutungen wie für Formel II bzw. IIa.

Da die vollständig umgesetzten Epoxyacrylate der Formel IIa praktisch keine Epoxygruppen mehr enthalten, lassen sie sich mit cyclischen Anhydriden von polycarbonsäuren zur Reaktion bringen. Dabei reagieren die aliphatischen Hydroxylgruppen (Formel IIa) mit dem cyclischen Anhydrid unter Ringöffnung und Halbesterbildung. Pro umgesetzte Hydroxylgruppe entsteht dabei eine an das Harz gebundene Carbonsäure. Die Reaktion geschieht derart, dass das Epoxyacrylat der Formel IIa mit dem cyclischen Anhydrid gegebenenfalls in Anwesenheit eines Katalysators und eines Polymerisationsinhibitors bei erhöhter Temperatur umgesetzt wird. Die OH-Gruppen der Verbindungen der Formel IIa werden dabei unter Ringöffnung des Anhydrides ganz oder teilweise acyliert. Dabei wird das Anhydrid in aequimolaren Mengen bezüglich der Hydroxylgruppen oder im Unterschuss eingesetzt. Es ist dabei vorteilhaft, dass die Epoxyacrylate der Formel IIa keine Epoxygruppen mehr aufweisen, ansonsten eine Gelbildung eintritt. Die Reaktion ist als solche bekannt.

Als cyclische Anhydride der Polycarbonsäuren kommen z.B. Bernsteinsäureanhydrid, Maleinsäureanhydrid, Glutarsäureanhydrid, Tetrahydrophthalsäureanhydrid, Itakonsäureanhydrid, Phthalsäureanhydrid, Hexahydrophthalsäureanhydrid, 3-Methyl-, 4-Methyl-, 3-Ethyl- und 4-Ethyl-hexahydrophthalsäureanhydrid, 3-Methyl-, 4-Methyl-, 3-Ethyl- und 4-Ethyl-tetrahydrophthalsäureanhydrid und Trimellithsäureanhydrid in Betracht.

Bevorzugte Anhydride sind Bernsteinsäure-, Tetrahydrophthalsäure-, Hexahydrophthalsäure- und Phthalsäure-Anhydrid.

Als Katalysator kommen z.B. Amine, wie z.B. Triethylamin, Benzyldimethylamin, Pyridin oder Dimethylaminopyridin, oder Triphenylphosphin oder Metallsalze, wie Chrom- oder Zirkoniumverbindungen, in Frage.

Gegebenenfalls kann dem Reaktionsmedium ein Lösungsmittel zugesetzt werden, da die Epoxyacrylate der Formel II als Feststoffe vorliegen. Dieses muss aber gegenüber dem cyclischen Anhydrid inert sein. Hydroxylgruppen aufweisende Lösungsmittel kommen daher nicht in Frage. Als Lösungsmittel kommen z.B. die für die Umsetzung mit den ethylenisch ungesättigten Carbonsäuren oben genannten Lösungsmittel in Betracht, sofern sie keine mit Anhydriden reagierenden funktionellen Gruppen enthalten.

Die Reaktionstemperatur bewegt sich zweckmässig zwischen 60 und 140°C, und als Polymerisationsinhibitoren kommen z.B. Hydrochinon, Hydrochinonmonomethylether und 2,6-Di-tert.-butyl-p-kresol in Frage.

Es ist vorteilhaft, in das Reaktionsmedium trockene Luft einzuleiten. In einer bevorzugten Ausführungsform der Erfindung werden die Epoxyacrylate der Formel II ohne Isolierung in der gleichen Reaktionsapparatur zu den mit Carboxylgruppen modifizierten Derivaten der Formel III weiter umgesetzt.

Eine Isolierung und Reinigung der neuen carboxylgruppenhaltigen Epoxyacrylate der Formel m ist in der Regel nicht nötig; die Reaktionslösung kann als solche weiterverwendet werden.

Infolge der im Molekül vorhandenen ungesättigten Gruppen sind die Epoxyacrylate der Formel II und die carboxylgruppenhaltigen Epoxyacrylate der Formel III thermisch und photochemisch vernetzbar. Sie können deshalb als Acrylatkomponenten z.B. in Photoresistformulierungen für die Herstellung von Lötstoppresists oder Primärresists nach bekannten Verfahren verwendet und appliziert werden, wie z.B in der am 2. Juli 1993 hinterlegten Schweiz. Patentanmeldung Nr. 2005/93-4 "Photopolymerisierbare Zusammensetzung", und ergeben Resistschichten mit verbesserten thermischen, mechanischen, elektrischen und chemischen Eigenschaften. Die daraus gewonnenen Resistformulierungen werden vor allem auf dem Gebiet der Leiterplatten z.B. als Lötstoppresist oder als Primärresist (Ätzresist oder Galvanoresist), und der Druckplatten angewandt. Als Entwickler kommen sowohl wässrige als auch wässrig/organische oder organische Systeme in Frage. Wegen dem Vorliegen von Carboxylgruppen in den Verbindungen der Formel III sind diese vor allem für die Herstellung von wässrig-alkalisch entwickelbaren Photoresists geeignet.

Gegenüber niedermolekularen Epoxyacrylaten in Formulierungen, die hochmolekulare Binderpolymere enthalten, ist es überraschend, dass Formulierungen mit höhermolekularen Epoxyacrylaten ohne Zusatz von Binderpolymeren keinen Verlust an sondern eine Verbesserung der Photoempfindlichkeit aufweisen, und dass auch keine Erhöhung der Klebrigkeit erfolgt. Des weiteren ist eine bessere Kantendeckung der Leiterzüge bei Verwendung als Lötstoppresist gegeben. Da keine zusätzlichen Binderpolymere in derartigen Formulierungen eingesetzt werden, sind weitere Vorteile bezüglich der thermischen, mechanischen und elektrischen Eigenschaften sowie speziell der chemischen Beständigkeit der daraus gewonnenen Resistzusammensetzungen gegeben. Ferner weisen die erfindungsgemässen Epoxyacrylate der Formel II und die carboxylgruppenhaltigen Epoxyacrylate der Formel III eine erhöhte Glasumwandlungstemperatur auf.

Die folgenden Beispiele veranschaulichen die Erfindung, ohne sie darauf zu limitieren.

### Herstellungsbeispiele

### Avancierte Epoxykresolnovolake

### Beispiel 1:

4000,00 g (18,58 Mol Epoxygruppen) Epoxykresolnovolak ECN 1299 (Lieferant CIBA-GEIGY) werden vorgelegt und mit 1780 g Methoxypropylacetat (MPA) durch Erwärmen auf 100°C gelöst. Man gibt 4,00 g einer 5%-igen Lösung von Tetramethylammoniumchlorid (TMAC) in Ethanol zu und rührt während 10 Minuten; dann erhöht man die Temperatur der erhaltenen klaren Lösung auf 130°C und versetzt mit 165,78 g (0,73 Mol) Bisphenol A. Man lässt bei 130°C reagieren und verfolgt den Fortschritt der Reaktion mittels Titration der Epoxygruppen sowie Viskositätsbestimmung im Brookfield-Viskosimeter bei 25°C, Spindel #31 (für die Messung der Viskosität werden die Proben mit Methoxypropylacetat auf 50%-Festkörpergehalt herunterverdünnt).

| | | |
|---|---|---|
| Anfangswerte: | Epoxywert = 3,09 Mol/kg | Viskosität = 141 mPa.s |
| 1h Reaktionszeit: | Epoxywert = 3,03 Mol/kg | |
| 2,5 h Reaktionszeit: | | Viskosität = 319 mPa.s |
| 3,5 h Reaktionszeit: | Epoxywert = 2,85 Mol/kg | |
| 5 h Reaktionszeit: | | Viskosität = 474 mPa.s |
| 6 h Reaktionszeit: | Epoxywert = 2,85 Mol/kg | Viskosität = 571 mPa.s |

Nach 6 Stunden bei 130°C wird die Reaktion abgestellt (nach den ersten 2 Stunden Reaktionszeit verändern sich die Werte nur noch wenig).

Analytische Daten des Reaktionsprodukts:

| | |
|---|---|
| Gehaltsbestimmung (Trockengewicht): | 68,4% |
| Epoxywert (titrimetrisch): | 2,85 Mol/kg (Lösung) |
| Brookfield-Viskosität, 25°; Sp.#31: | 571 mPa.s (50%-Lsg. in MPA) |
| GPC (Gelpermeationschromatographie; Polystyroleichung): | Mw = 16050; Mn = 2059 |

Das erhaltene Produkt entspricht der Formel I, worin Y 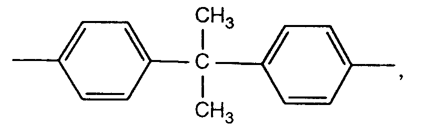 x die Zahl 1, R Methyl und n die Zahlen O bis 6 bedeuten.

### Epoxyacrylate von avancierten Epoxykresolnovolaken

### Beispiel 2 (Beispiel 1 mit 100 Mol% Acrylsäure umgesetzt):

Während der gesamten Reaktionsdauer wird ein Luftstrom unter Niveau eingeleitet und durch intensives Rühren für eine gute Verteilung der Luftblasen gesorgt. Die Luft soll zweckmässig sauber, trocken und ölfrei sein.
5594,90 g des Reaktionsproduktes gemäss obigem Beispiel 1 (63%-ige Lösung in Methoxypropylacetat; 15,95 Mol Epoxygruppen), 446,50 g Methoxypropylacetat und 4,67 g 2,6-Di-tert.butyl-p-kresol werden vorgelegt und auf 100°C Innentemperatur aufgeheizt. Dann fügt man die restlichen Reaktionskomponenten zu, nämlich: 1149,00 g Acrylsäure und 93,50 ml Nuosynchromium 5 (Produkt der Firma HARCROS-Durham Chemicals, Durham DH3 1QX, GB) (als 10%-ige Lösung in Methoxypropylacetat verdünnt).
Man lässt bei 105-110°C Innentemperatur reagieren. Die Reaktion verläuft am Anfang exotherm, so dass 15 Min. nach Reaktionsbeginn mit einem Wasserbad gekühlt werden muss.

Nach ca. 45 Min. Reaktionszeit wird das Kühlbad entfernt und mit einem Oelbad weitergeheizt. Man verfolgt den Reaktionsfortschritt mittels Titration des Säuregehalts:

| | |
|---|---|
| Anfangswert: | 2,19 Mol/kg |
| 1h Reaktionszeit: | 0,89 Mol/kg |
| 2 h Reaktionszeit: | 0.55 Mol/kg |
| 3 h Reaktionszeit: | 0,09 Mol/kg |
| 5 h Reaktionszeit: | 0,11 Mol/kg |
| 7,5 h Reaktionszeit: | 0,065 Mol/kg |

Nach 7,5 h Reaktionszeit wird die Reaktion abgestellt, und das Produkt wird warm abgefüllt.

Analytische Daten des Reaktionsprodukts:

| | | |
|---|---|---|
| 1. | Gehaltsbestimmung (Trockengewicht): | 68% |
| 2. | Epoxywert (titrimetrisch): | 0,05 Mol/kg |
| 3. | Säuregehalt (titrimetrisch): | 0,065 Mol/kg |
| 4. | Brookfield-Viskosität, 25°, Sp.#31: | 28100 mPa.s (Messlösung auf 63,6% mit MPA verdünnt). |
| 5. | GPC: | Mw = 23978; Mn = 3132 |

Das Produkt entspricht der Formel II, worin x, Y und R die im Beispiel 1 angegebene Bedeutung haben, M die Gruppe 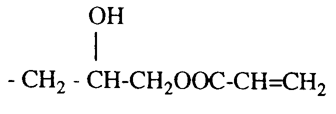 bedeutet und n die Zahlen 0 bis 6 darstellt.

### Beispiel 3

Als Apparatur verwendet man ein 500 ml Reaktionsgefäss, ausgestattet mit Rührer, Thermometer, Rückflusskühler und einem Einleitungsrohr für Luft. Zur Inhibierung der Polymerisation der Acrylate wird während der Reaktion ein schwacher Luftstrom unter Niveau eingeleitet. Die Heizung geschieht mittels thermostatisierbarem Oelbad. Im Reaktor werden 313,27 g (0,73 Mol OH-Gruppen) des Reaktionsprodukts aus Beispiel 2 und 147,14 g Methoxypropylacetat vorgelegt und auf 100°C Innentemperatur aufgeheizt. Dann fügt man 36,37 g (0,36 Mol) Bernsteinsäureanhydrid und 1,25 g Pyridin als Katalysator zu und lässt 4 Stunden bei dieser Temperatur reagieren. Das homogene Reaktionsprodukt wird ohne zusätzliche Reinigung weiterverwendet.

### Analytische Daten des Reaktionsproduktes:

| | | |
|---|---|---|
| 1. | Festkörpergehalt: | 51% |
| 2. | Säuregehalt (titrimetrisch): | 0,785 Mol/kg |
| 3. | Viskosität (Brookfield): | 2890 mPa.s bei 25°C |

Das Produkt entspricht der Formel III, worin x, Y und R die im Beispiel 1 angegebene Bedeutung haben, R₁ und R₂ H, n die Zahl 0 bis 6 und A 50 Mol% der Gruppe 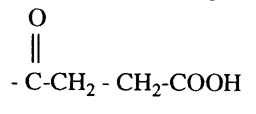 und 50 Mol% -H darstellt.

### Beispiel 4

Apparatur gemäss Beispiel 3.
Im Reaktor werden 341.18 g (0,73 Mol OH-Gruppen) des Reaktionsproduktes aus Beispiel 2 (Festkörpergehalt = 69,2%) und 204 g Methoxypropylacetat vorgelegt und auf 105°C Innentemperatur aufgeheizt. Dann gibt man 72,33 g (0,475 Mol) Tetrahydrophthalsäureanhydrid und 1,55 g Pyridin als Katalysator zu und lässt 8 Stunden bei einer Innentemperatur von 110°C reagieren. Das homogene Reaktionsprodukt wird ohne zusätzliche Reinigung weiterverwendet.

### Analytische Daten des Reaktionsproduktes:

| | | |
|---|---|---|
| 1. | Festkörpergehalt: | 49,7% |
| 2. | Säuregehalt (titrimetrisch): | 0,82 Mol/kg |

Das Produkt entspricht der Formel III, worin x, Y, R, R₁, R₂ und n die im Beispiel 3 angegebene Bedeutung haben und A 65 Mol% der Gruppe 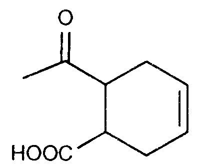 und 35 Mol% -H darstellt.

### Avancierte Epoxykresolnovolake (gemäss Formel I)

### Beispiel 5 [Verlängerung mit Tetrabrombisphenol A]:

2000,00 g (9,29 Mol Epoxygruppen) Epoxykresolnovolak ECN 1299 werden vorgelegt und mit 940 g Methoxypropylacetat (MPA) durch Erwärmen auf 100°C gelöst. Man gibt 2,00 g einer 5%igen Lösung von Tetramethylammoniumchlorid (TMAC) in Ethanol zu und rührt während 10 Minuten; dann erhöht man die Temperatur der erhaltenen klaren Lösung auf 130°C und versetzt mit 200,00 g (0,36 Mol) Tetrabrombisphenol A. Man lässt bei 130°C reagieren und verfolgt den Fortschritt der Reaktion mittels Titration der Epoxygruppen sowie Viskositätsbestimmung. Nach 6 Stunden bei 130°C wird die Reaktion abgestellt. Das erhaltene Reaktionsprodukt kann direkt für die nächste Stufe weiterverwendet werden.

### Analytische Daten:

| | | |
|---|---|---|
| 1. | Gehaltsbestimmung (Trockengewicht): | 71% |
| 2. | Epoxywert (titrimetrisch): | 2,75 Mol/kg (Lösung) |
| 3. | Brookfield-Viskosität, 25°C, Sp.#31: | 571 mPa.s (50%-Lsg.) |
| 4. | GPC (Polystyrol-Eichung): | Mw=19492; Mn=2126 |

### Beispiel 6 [Verlängerung mit Bis-(4-hydroxyphenyl)-sulfon]:

- 1400,00 g: ECN 1299,
- 627,00 g: Methoxypropylacetat,
- 1,40 g: 5%-Tetramethylammoniumchlorid in Ethanol, und
- 63,42 g: Bis-(4-hydroxyphenyl)-sulfon
werden gemäss diesem Beispiel 5 während 6 Stunden bei 130°C umgesetzt. Das erhaltene Reaktionsprodukt weist folgende analytische Daten auf:

| | | |
|---|---|---|
| 1. | Epoxywert (titrimetrisch): | 2,88 Mol/kg (Lösung) |
| 2. | GPC (Polystyrol-Eichung): | Mw=12863; Mn=1972 |

### Beispiel 7 [Verlängerung mit 4,4'-Dihydroxybiphenyl]:

- 200,00 g: ECN 1299,
- 89,00 g: Methoxypropylacetat,
- 0,20 g: 5%-Tetramethylammoniumchlorid in Ethanol, und
- 6,74 g: 4,4'-Dihydroxybiphenyl
werden gemäss Beispiel 5 während 6 Stunden bei 130°C umgesetzt. Das erhaltene Reaktionsprodukt weist folgende analytische Daten auf:

| | | |
|---|---|---|
| 1. | Epoxywert (titrimetrisch): | 2,82 Mol/kg (Lösung) |

### Beispiel 8 [Verlängerung mit Bisphenol A]:

- 1600,00 g: ECN 1299,
- 727,00 g: Methoxypropylacetat,
- 1,60 g: 5%-Tetramethylammoniumchlorid in Ethanol, und
- 92,40 g: Bisphenol A
werden gemäss Beispiel 5 während 6 Stunden bei 130°C umgesetzt. Das erhaltene Reaktionsprodukt weist folgende analytische Daten auf:

| | |
|---|---|
| 1. Gehaltsbestimmung (Trockengewicht): | 67% |
| 2. Epoxywert (titrimetrisch): | 2,74 Mol/kg |
| 3. GPC (Polystyrol-Eichung): | Mw=25725;Mn=2257 |

### Epoxyacrylate von avancierten Epoxykresolnovolaken (gemäss Formel II)

### Beispiel 9; [Bsp. 5 mit 75 Mol% Acrylsäure umgesetzt]

Während der gesamten Reaktionsdauer wird ein Luftstrom unter Niveau eingeleitet und durch intensives Rühren für eine gute Verteilung der Luftblasen gesorgt. Die Luft sollte sauber, trocken und ölfrei sein. 4646,30 g des Reaktionsproduktes gemäss Beispiel 5 (ca. 70%-ige Lösung in Methoxypropylacetat; 12,36 Mol Epoxygruppen), 702,70 g Methoxypropylacetat und 3,91 g 2,6-Di-tert.butyl-p-kresol werden vorgelegt und auf 80°C Innentemperatur aufgeheizt. Dann fügt man die restlichen Reaktionskomponenten zu, nämlich: 667,90 g Acrylsäure und 78,20 ml Nuosyn-chromium-5 verdünnt, 10% (10,00 g Handelsprodukt + 90,00 g Methoxypropylacetat). Man lässt bei 105° - 110°C Innentemperatur reagieren und verfolgt den Reaktionsfortschritt mittels Titration des Säuregehaltes. Nach 2,5 Stunden Reaktionszeit beträgt der Säuregehalt 0,00 Mol/kg, die Reaktion wird beendet, und das Produkt wird im warmen Zustand abgefüllt

### Analytische Daten:

| | |
|---|---|
| 1. Gehaltsbestimmung (Trockengewicht): | 65,40 % |
| 2. Epoxywert (titrimetrisch): | 0,60 Mol/kg |
| 3. Säuregehalt (titrimetrisch): | 0,00 Mol/kg |
| 4. Brookfield-Viskosität, 25°C, Sp.#31: | 675 mPa.s-als 50%-ige Lsg. |
| 5. GPC (Polystyrol-Eichung): | Mw=25084; Mn=3004 |

### Beispiel 10 [Bsp. 5 mit 10 Mol% Acrylsäure umgesetzt]

Nach dem in Beispiel 9 angegebenen Verfahren werden
- 500,00 g: Reaktionsprodukt gemäss Beispiel 5 verdünnt (57%-ige Lösung in Methoxypropylacetat; 1,12 Mol Epoxygruppen),
- 8,03 g: Acrylsäure,
- 0,29 g: 2,6-Di-tert.butyl-p-kresol, und
- 5,84 ml: Nuosynchromium-5, 10%ig in Methoxypropylacetat
umgesetzt. Das Reaktionsprodukt weist folgende analytische Daten auf:

| | |
|---|---|
| 1. Gehaltsbestimmung (Trockengewicht); | 57,40% |
| 2. Epoxywert (titrimetrisch): | 1,99 Mol/kg |
| 3. Säuregehalt (titrimetrisch): | 0,05 Mol/kg |
| 4. Brookfield-Viskosität, 25°C, Sp.#31: | 3510 mPa.s |
| 5. GPC (Polystyrol-Eichung): | Mw=24113; Mn=2565 |

### Beispiel 11 [Bsp. 1 mit 65 Mol% Acrylsäure umgesetzt]

Nach dem in Beispiel 9 angegebenen Verfahren werden
- 900,00 g: Reaktionsprodukt gemäss Beispiel 1 (69%-ige Lösung in Methoxypropylacetat; 2,56 Mol/kg Epoxygruppen),
- 119,72 g: Acrylsäure,
- 105,04 g: Methoxypropylacetat,
- 0,74 g: 2,6-Di-tert.butyl-p-kresol, und
- 14,81 ml: Nuosynchromium-5, 10%ig in Methoxypropylacetat
während 4 Stunden umgesetzt. Das Reaktionsprodukt weist folgende analytische Daten auf:

| | |
|---|---|
| 1. Gehaltsbestimmung (Trockengewicht): | 67,40% |
| 2. Epoxywert (titrimetrisch): | 0,81 Mol/kg |
| 3. Säuregehalt (titrimetrisch): | 0,05 Mol/kg |
| 4. Brookfield-Viskosität, 25°C, Sp.#31: | 43400 mPa.s |
| 5. GPC (Polystyrol-Eichung): | Mw=27770; Mn=2815 |

### Beispiel 12 [Bsp. 8 mit 75 Mol% Acrylsäure umgesetzt]

Nach dem in Beispiel 9 angegebenen Verfahren werden
- 200,00 g: Reaktionsprodukt gemäss Beispiel 8 (0,548 Mol Epoxygruppen),
- 29,61 g: Acrylsäure,
- 31,32 g: Methoxypropylacetat,
- 0,17 g: 2,6-Di-tert.butyl-p-kresol, und
- 3,40 ml: Nuosynchromium-5, 10%ig in Methoxypropylacetat
umgesetzt. Das Reaktionsprodukt weist folgende analytische Daten auf:

| | |
|---|---|
| 1. Gehaltsbestimmung (Trockengewicht) | 65,20% |
| 2. Epoxywert (titrimetrisch) | 0,51 Mol/kg |
| 3. Säuregehalt (titrimetrisch) | 0,05 Mol/kg |
| 4. GPC (Polystyrol-Eichung) | Mw=44949; Mn=2997 |

### Beispiel 13 [Bsp. 6 mit 100 Mol% Acrylsäure umgesetzt]

Nach dem in Beispiel 2 angegebenen Verfahren werden
- 298,00 g: Reaktionsprodukt gemäss Beispiel 6 (0,854 Mol Epoxygruppen),
- 61,60 g: Acrylsäure,
- 52,00 g: Methoxypropylacetat,
- 0,27 g: 2,6-Di-tert.butyl-p-kresol, und
- 5,42 ml: Nuosynchromium-5, 10%ig in Methoxypropylacetat
während 8 Stunden umgesetzt. Das Reaktionsprodukt weist folgende analytische Daten auf:

| | |
|---|---|
| 1. Epoxywert (titrimetrisch): | 0,03 Mol/kg |
| 2. Säuregehah (titrimetrisch): | 0,06 Mol/kg |

### Beispiel 14 [Bsp. 7 mit 100 Mol% Acrylsäure umgesetzt]

Nach dem in Beispiel 2 angegebenen Verfahren werden
- 295,00 g: Reaktionsprodukt gemäss Beispiel 7 (0,83 Mol Epoxygruppen),
- 60,06 g: Acrylsäure,
- 50,00 g: Methoxypropylacetat,
- 0,36 g: 2,6-Di-tert.butyl-p-kresol, und
- 5,34 ml: Nuosynchromium-5, 10%ig in Methoxypropylacetat
während 8 Stunden umgesetzt. Das Reaktionsprodukt weist folgende analytische Daten auf:

| | |
|---|---|
| 1. Epoxywert (titrimetrisch): | 0,06 Mol/kg |
| 2. Säuregehalt (titrimetrisch): | 0,00 Mol/kg |

### Carboxylgruppenhaltige Acrylate von avancierten Epoxykresolnovolaken (gemäss Formel III)

### Beispiel 15 [Bsp. 2 mit 70 Mol% Bernsteinsäureanhydrid umgesetzt]

Nach dem in Beispiel 3 angegebenen Verfahren werden
- 434,50 g: Reaktionsprodukt gemäss Beispiel 2 (66%-ige Lösung mit OH-Gruppengehalt=2,1 Mol/kg; 0,92 Mol OH-Gruppen),
- 64,45 g: Bernsteinsäureanhydrid,
- 41,38 g: Methoxypropylacetat, und
- 1,76 g: Pyridin
während 6 Stunden umgesetzt. Das Reaktionsprodukt weist folgende analytische Daten auf:

| | |
|---|---|
| 1. Gehaltsbestimmung (Trockengewicht): | 65,60% |
| 2. Säuregehalt (titrimetrisch): | 1,31 Mol/kg |

### Beispiel 16 [Bsp. 2 mit 80 Mol% Tetrahydrophthalsäureanhydrid umgesetzt, mit 4-Dimethylaminopyridin als Katalysator]

Nach dem in Beispiel 3 angegebenen Verfahren werden
- 500,00 g: Reaktionsprodukt gemäss Beispiel 2 (1,04 Mol OH-Gruppen),
- 126,83 g: Tetrahydrophthalsäureanhydrid,
- 276,83 g: Methoxypropylacetat, und
- 0,23 g: 4-Dimethylaminopyridin
während 7 Stunden umgesetzt. Das Reaktionsprodukt weist folgende analytische Daten auf:

| | |
|---|---|
| 1. Gehaltsbestimmung (Trockengewicht): | 48,40% |
| 2. Säuregehalt (titrimetrisch): | 1,02 Mol/kg |
| 3. Brookfield-Viskosität, 25°C, Sp.#31: | 2340 mPa.s |

### Beispiel 17 [Bsp. 2 mit 65 Mol% Phthalsäureanhydrid umgesetzt]

Nach dem in Beispiel 3 angegebenen Verfahren werden
- 328,80 g: Reaktionsprodukt gemäss Beispiel 2 (0,70 Mol OH-Gruppen),
- 67,86 g: Phthalsäureanhydrid,
- 194,77 g: Methoxypropylacetat, und
- 1,48 g: Pyridin
während 8 Stunden umgesetzt. Das Reaktionsprodukt weist folgende analytische Daten auf:

| | |
|---|---|
| 1. Gehaltsbestimmung (Trockengewicht): | 43,90% |
| 2. Säuregehalt (titrimetrisch) | 0,88 Mol/kg |

### Beispiel 18 [Bsp. 13 mit 65 Mol% Tetrahydrophthalsäureanhydrid umgesetzt]

Nach dem in Beispiel 3 angegebenen Verfahren werden
- 398,00 g: Reaktionsprodukt gemäss Beispiel 13 (0,85 Mol OH-Gruppen),
- 89,00 g: Tetrahydrophthalsäureanhydrid,
- 190,00 g: Methoxypropylacetat, und
- 1,68g: Pyridin
während 6 Stunden umgesetzt. Das Reaktionsprodukt weist folgende analytische Daten auf:

| | |
|---|---|
| 1. Gehaltsbestimmung (Trockengewicht): | 51,10% |
| 2. Säuregehalt (titrimetrisch): | 0,95 Mol/kg |

### Beispiel 19 [Bsp. 14 mit 65 Mol% Tetrahydrophthalsäureanhydrid umgesetzt]

Nach dem in Beispiel 3 angegebenen Verfahren werden
- 400,00 g: Reaktionsprodukt gemäss Beispiel 14 (0,83 Mol OH-Gruppen),
- 86,76 g: Tetrahydrophthalsäureanhydrid,
- 211,20 g: Methoxypropylacetat, und
- 1,76g: Pyridin
während 4,5 Stunden umgesetzt. Das Reaktionsprodukt weist folgende analytische Daten auf:

| | |
|---|---|
| 1. Gehaltsbestimmung (Trockengewicht): | 46,00% |
| 2. Säuregehalt (titrimetrisch): | 0,91 Mol/kg |

### Epoxymethacrylate von avancierten Epoxykresolnovolaken (gemäss Formel II)

### Beispiel 20 [Bsp. 1 mit 50 Mol% Methacrylsäure umgesetzt]

Nach dem in Beispiel 9 angegebenen Verfahren werden
- 300,00 g: Reaktionsprodukt gemäss Beispiel 1 (70%-ige Lösung in Methoxypropylacetat; 2,85 Mol/kg Epoxygruppen; entspricht 0,855 Mol Epoxygruppen),
- 36,80 g: Methacrylsäure,
- 37,96 g: Methoxypropylacetat,
- 0,25 g: 2,6-Di-tert.butyl-p-kresol, und
- 4,94 ml: Nuosynchromium-5, 10%ig in Methoxypropylacetat
während 4 Stunden umgesetzt. Das Reaktionsprodukt weist folgende analytische Daten auf:

| | |
|---|---|
| 1. Gehaltsbestimmung (Trockengewicht): | 64,80% |
| 2. Epoxywert (titrimetrisch): | 1,10 Mol/kg |
| 3. Säuregehalt (titrimetrisch): | 0,00 Mol/kg |
| 4. Brookfield-Viskosität, 25°C, Sp.#31: | 27000 mPa.s |
| 5. GPC (Polystyrol-Eichung): | Mw=28981; Mn=2809 |

### Applikationsbeispiele

### Generell

Als Beschichtungssubstrate dienen gereinigte kupferkaschierte Elektroniklaminate oder prozessierte Leiterplatten, die ein Leiterbahnmuster aufweisen.
Die Resistrezepturen werden durch Zusammenmischen und Lösen der in den Beispielen aufgeführten Komponenten, eventuell gefolgt von einer Filtration, hergestellt. Alle Operationen sind unter Gelblichtschutz durchzuführen.
Für Testzwecke kann man die Rezepturen mit einem Drahtrakel auf die Leiterplatte beschichten. Für grössere Serien werden Vorhanggiessverfahren oder Walzenbeschichtung sowie Siebdruckverfahren eingesetzt.
Die Trocknung geschieht in einem Umluftofen. Zur Belichtung verwendet man kommerzielle Geräte mit 5000 W Metallhalogenid - dotierten Quecksilberhochdruckstrahler. Die Entwicklung wird in kommerziellen Durchlaufentwicklungsgeräten durchgeführt. Zur Beurteilung von Photoempfindlichkeit und Auflösungsvermögen belichtet man durch Stufenkeil und Auflösungskeil der Fa. Stouffer und evaluiert das Ergebnis anhand des entwickelten Resistbildes.

### Rezeptur 1.1 enthält ein erfindungsgemässes Epoxyacrylat:

- 80,00 g: Reaktionsprodukt gemäss Beispiel 2 (als 50%-ige Lösung in Methoxypropylacetat)
- 13,00 g: Sartomer 295 (Pentaerythritoltetraacrylat)
- 3,00 g: Irgacure 907 (Photoinitiator der Fa. CIBA AG, Basel)
- 1,50 g: Quantacure ITX (Isopropylthioxanthon; Sensibilisator)
- 0,15 g: Orasolblau GN (Farbstoff der Fa. CIBA AG, Basel)

### Rezeptur 1.2: Vergleichsbeispiel, mit einem hochmolekularen Binderpolymer aber ohne das erfindungsgemässe Epoxyacrylat:

- 133,33 g: Scripset 550E-Lösung (30%-ige Lösung in Methoxypropylacetat; Binderpolymer der Firma Monsanto; Styrolmaleinsäurecopolymer)
- 13,00 g: Sartomer 295
- 3,00 g: Irgacure 907
- 1,50 g: Quantacure ITX
- 0,15g: Orasolblau GN

### Ergebnis

| | Rezeptur 1.1 | Rezeptur 1.2 (Vergleich) |
|---|---|---|
| Festkörpergehalt | 59% | 38,2% |
| Viskosität 25°C (Epprecht) | 2200 mPa.s | 3000 mPa.s |
| Trockenschichtdicke | 12µm | 12µm |
| Trocknungsbedingungen | 5 Min. 80°C | 5 Min. 80°C |
| Belichtung | 150 mJ/cm² | 150 mJ/cm² |
| Entwicklung | 1% Natriumcarbonat 35°C | 1% Natriumcarbonat 35°C |
| Letzte sichtbare Keilstufe | 11 | 2-3 |

Die Rezeptur 1.1 mit dem erfindungsgemässen Epoxyacrylat (Beispiel 2) weist trotz dem wesentlich höheren Festkörpergehalt eine niedrigere Viskosität als diejenige der Rezeptur 1.2 auf Die Photoempfindlichkeit ist mit 11 abgebildeten Keilstufen sehr viel höher als beim Einsatz der Vergleichsrezeptur 1.2 mit nur 2 bis 3 abgebildeten Keilstufen.

## Patentansprüche

1. Epoxyacrylate der Formel II 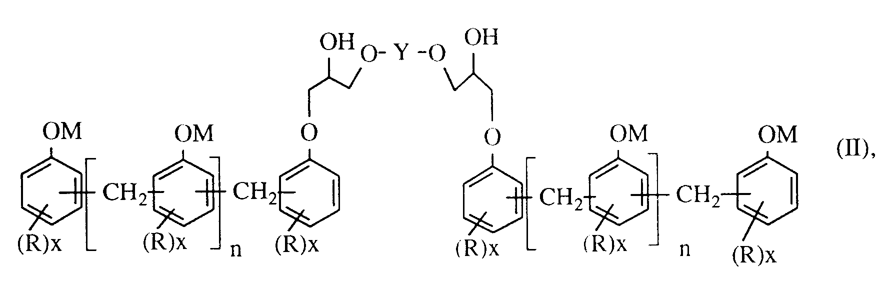 worin
M die Gruppe der Formeln 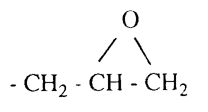 oder 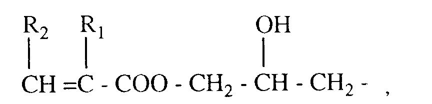
R₁ -H oder -CH₃, R₂ -H, -CH₃ oder Phenyl,
R C₁-C₄ Alkyl oder Halogen, vorzugsweise CH₃ oder Br,
x eine ganze Zahl von 0 bis 3, vorzugsweise 0 oder 1, und
Y ein Brückenglied der Formeln 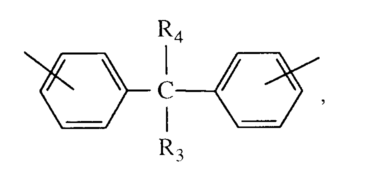 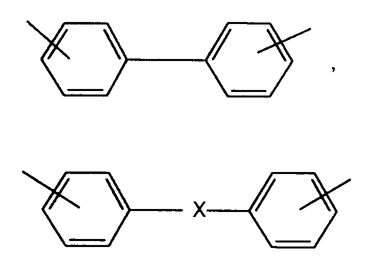 oder 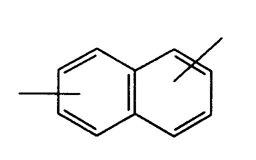 bedeuten,
wobei R₃ und R₄ unabhängig voneinander Wasserstoff oder C₁-C₄ Alkyl bedeuten oder R₃ und R₄ zusammen mit dem C-Atom, an dem sie gebunden sind, einen 5- oder 6-gliedrigen Kohlenwasserstoff-Ring bilden, und die aromatischen Reste des Brückengliedes Y unsubstituiert oder durch Halogen oder C₁-C₄ Alkyl substituiert sind,
X -S-, -O-, oder -SO₂-, und
n eine ganze Zahl von 0 bis 300, bedeuten,
wobei mindestens 10 Mol % der Reste M die Struktur der Formel 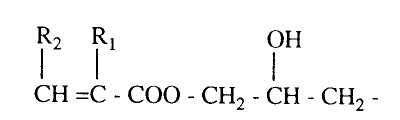 aufweisen, wobei R₁ und R₂ die oben angegebene Bedeutung haben.

2. Epoxyacrylate der Formel II gemäss Anspruch 1, worin R -H oder -CH₃, R₁ -H oder -CH₃, R₂ -H, x die Zahl 0 oder 1, n eine ganze Zahl von 0 bis 30 und Y ein Brückenglied der Formel 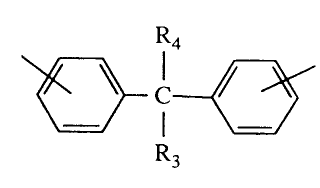 sind, worin
R₃ und R₄ -H oder C₁-C₄ Alkyl und die aromatischen Reste des Brückengliedes unsubstituiert oder durch Halogen oder C₁-C₄ Alkyl substituiert sind.

3. Epoxyacrylate der Formel II gemäss Anspruch 1, worin Y ein Brückenglied der Formel 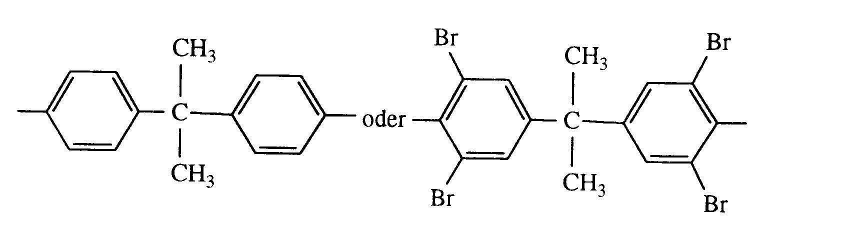 darstellt.

4. Epoxyacrylate der Formel II gemäss Anspruch 1, worin R₁ -H oder -CH₃ und R₂ -H sind.

5. Verfahren zur Herstellung der Epoxyacrylate der Formel II gemäss Anspruch 1, dadurch gekennzeichnet, dass ein avancierter Epoxynovolak der Formel I 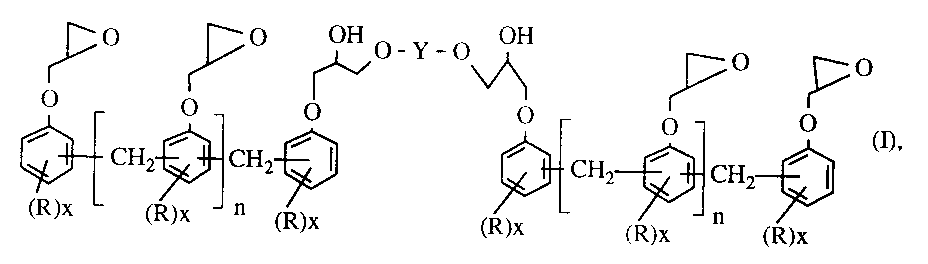 worin R, Y, n und x die im Anspruch 1 angegebene Bedeutung haben, mit einer ethylenisch ungesättigten Monocarbonsäure gegebenenfalls in Anwesenheit eines Katalysators und eines Polymerisationsinhibitors bei erhöhter Temperatur umgesetzt wird.

6. Carboxylgruppenhaltige Epoxyacrylate der Formel III 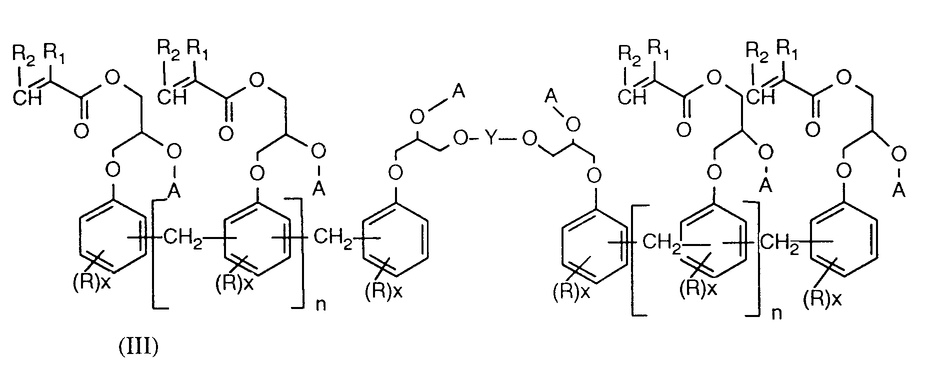 worin
A Wasserstoff oder die Gruppe der Formel 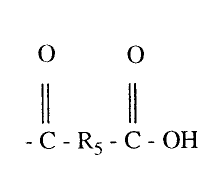 bedeutet, und
R₁, R₂, R, n und x die im Anspruch 1 angegebene Bedeutung haben, R₅ den Rest eines cyclischen Anhydrides einer Polycarbonsäure nach Entfernen des Anhydridrestes darstellt, und wobei mindestens 10 Mol % der Reste A die Struktur der obigen Formel 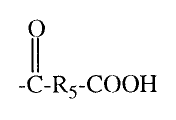 aufweisen, und
Y ein Brückenglied der Formeln 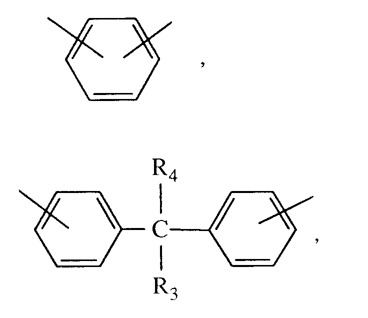 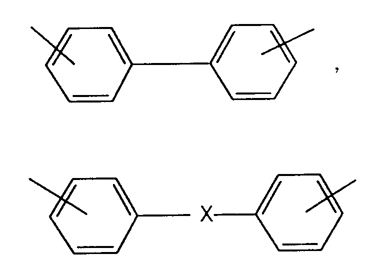 oder 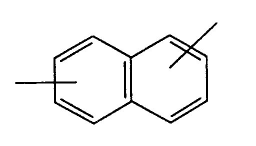 bedeutet,
worin R₃ und R₄ unabhängig voneinander Wasserstoff oder C₁-C₄ Alkyl bedeuten oder R₃ und R₄ zusammen mit dem C-Atom, an dem sie gebunden sind, einen 5- oder 6-gliedrigen Kohlenwasserstoff-Ring bilden, und die aromatischen Reste des Brückengliedes Y unsubstituiert oder durch Halogen oder C₁-C₄ Alkyl substituiert sind, und
X -S-, -O- oder -SO₂- bedeutet.

7. Verfahren zur Herstellung der carboxylgruppenhaltigen Epoxyacrylate der Formel III gemäss Anspruch 6, dadurch gekennzeichnet, dass ein Epoxyacrylat der Formel IIa mit einem cyclischen Anhydrid einer Polycarbonsäure gegebenenfalls in Anwesenheit eines Katalysators und eines Polymerisatonsinhibitors bei erhöhter Temperatur umgesetzt wird:
Formel IIa: 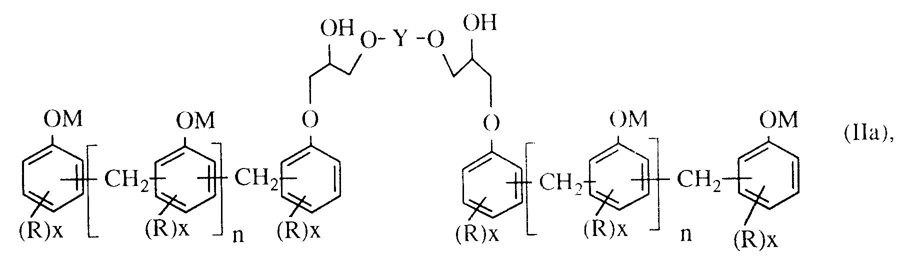 worin
M die Gruppe der Formel 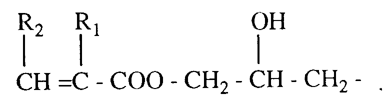
R₁ -H oder -CH₃, R₂ -H, -CH₃ oder Phenyl,
R C₁-C₄ Alkyl oder Halogen, vorzugsweise CH₃ oder Br,
x eine ganze Zahl von 0 bis 3, vorzugsweise 0 oder 1, und
Y ein Brückenglied der Formeln 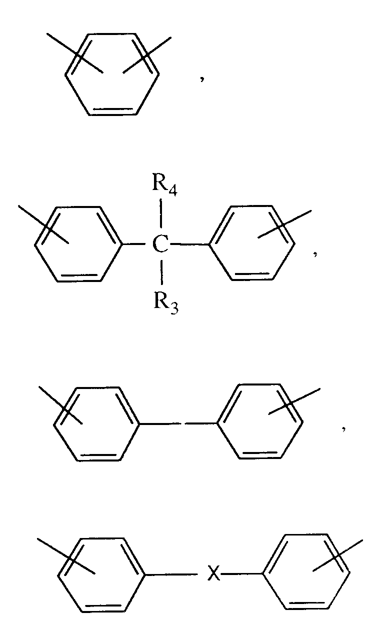 oder 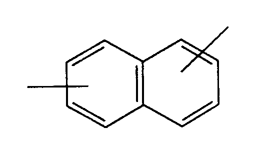 bedeuten, worin R₃ und R₄ unabhängig voneinander Wasserstoff oder C₁-C₄ Alkyl bedeuten oder R₃ und R₄ zusammen mit dem C-Atom, an dem sie gebunden sind, einen 5- oder 6-gliedrigen Kohlenwasserstoff-Ring bilden, und die aromatischen Reste des Brückengliedes Y unsubstituiert oder durch Halogen oder C₁-C₄ Alkyl substituiert sind,
X -S-, -O-, oder -SO₂-, und
n eine ganze Zahl von 0 bis 300, insbesondere von 0 bis 30 bedeuten.

8. Verwendung der Epoxyacrylate der Formel II gemäss Anspruch 1 als Acrylatkomponenten in Photoresistformulierungen.

9. Verwendung der Epoxyacrylate der Formel III gemäss Anspruch 6 als Acrylatkomponente in Photoresistformulierungen.

## Claims

1. An epoxy acrylate of formula II 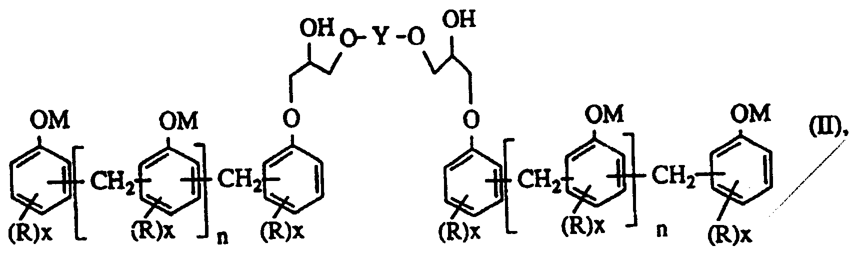 wherein
M is the group of formula 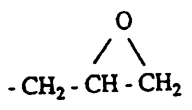 or 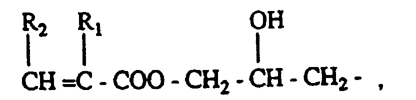
R₁ is -H or -CH₃, R₂ is -H, -CH₃ or phenyl,
R is C₁-C₄alkyl or halogen, preferably CH₃ or Br,
x is an integer from 0 to 3, preferably 0 or 1, and
Y is a linking group of formula 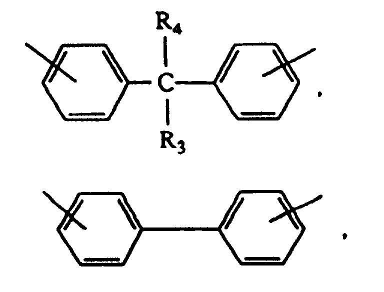 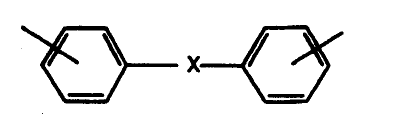 or 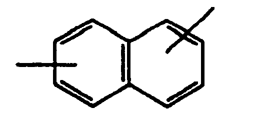 wherein R₃ and R₄ are each independently of the other hydrogen or C₁-C₄alkyl, or R₃ and R₄, together with the linking carbon atom, form a 5- or 6-membered hydrocarbon ring, and the aromatic radicals of the linking group Y are unsubstituted or substituted by halogen or C₁-C₄alkyl,
X is -S-, -O-, or -SO₂-, and
n is an integer from 0 to 300,
with the proviso that at least 10 mol% of the radicals M have the structure of formula 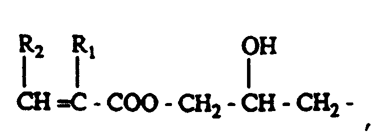 in which R1 and R2 are as defined above.

2. An epoxy acrylate of formula II according to claim 1, wherein R is -H or -CH₃, R₁ is -H or -CH₃, R₂ is -H, x is 0 or 1, n is an integer from 0 to 30, and Y is a linking group of formula 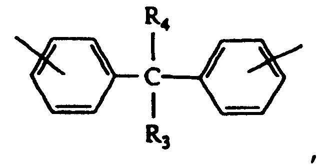 wherein R₃ and R₄ are -H or C₁-C₄alkyl and the aromatic radicals of the linking group are unsubstituted or substituted by halogen or C₁-C₄alkyl.

3. An epoxy acrylate of formula II according to claim 1, wherein Y is a linking group of formula

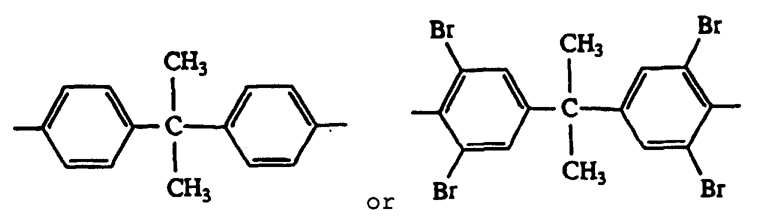

4. An epoxy acrylate of formula II according to claim 1, wherein R₁ is -H or -CH₃ and R₂ is -H.

5. A process for the preparation of an epoxy acrylate of formula II according to claim 1, which comprises reacting an advanced epoxy novolak of formula I 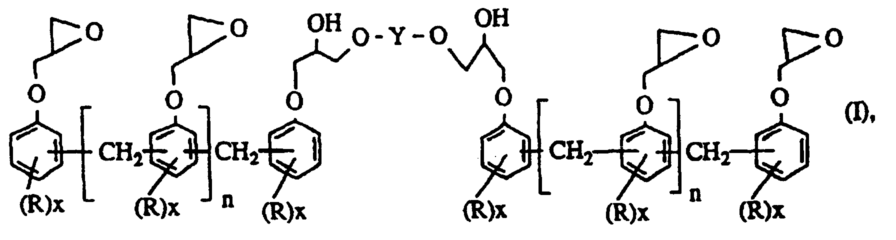 wherein R, Y, n and x are as defined in claim 1, with an ethylenically unsaturated monocarboxylic acid in the absence or presence of a catalyst and of a polymerisation inhibitor, at elevated temperature.

6. A carboxyl group-containing epoxy acrylate of formula III 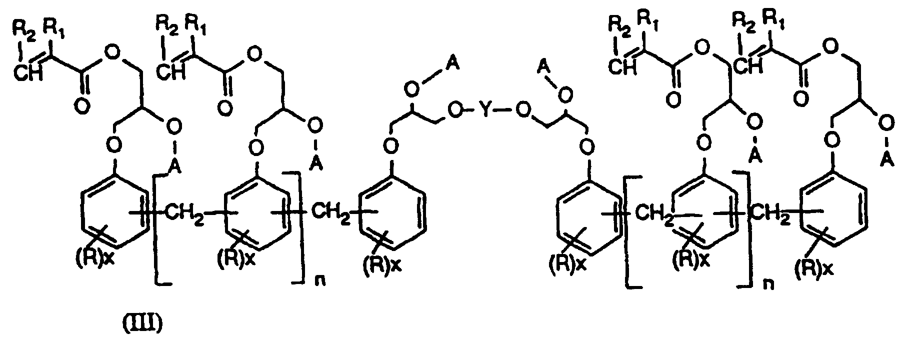 wherein
A is hydrogen or the group of formula 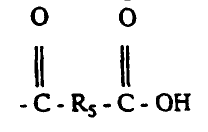 and R₁, R₂, R, n and x are as defined in claim 1, R₅ is the radical of a cyclic anhydride of a polycarboxylic acid after removal of the anhydride radical, and at least 10 mol% of the radicals A have the structure of the above formula 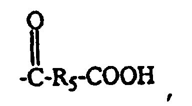 and
Y is a linking group of the formula 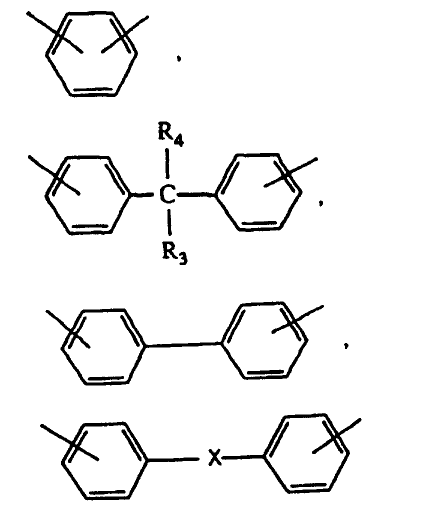 or 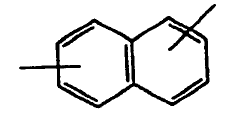 wherein R₃ and R₄ are independently of one another hydrogen or C₁-C₄alkyl or R₃ and R₄, together with the linking carbon atom, form a 5- or 6-membered hydrocarbon ring, and the aromatic radicals of the linking group Y are unsubstituted or substituted by halogen or C₁-C₄-alkyl, and
X is -S-, -O- or -SO₂-.

7. A process for the preparation of a carboxyl group-containing epoxy acrylate of formula III according to claim 6, which comprises reacting an epoxy acrylate of formula IIa with a cyclic anhydride of a polycarboxylic acid in the absence or presence of a catalyst and of a polymerisation inhibitor, at elevated temperature: formula IIa: 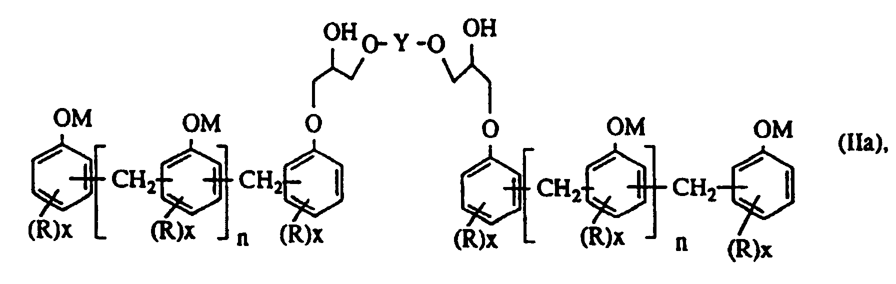 wherein
M is the group of the formula 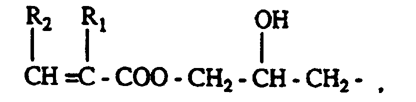
R₁ is -H or -CH₃, R₂ is -H, -CH₃ or phenyl,
R is C₁-C₄alkyl or halogen, preferably CH₃ or Br,
x is an integer from 0 to 3, preferably 0 or 1, and
Y is a linking group of formula 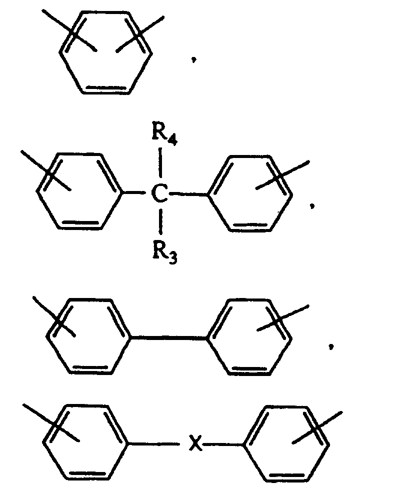 or 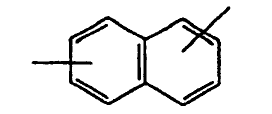 wherein R₃ and R₄ are each independently of the other hydrogen or C₁-C₄alkyl or R₃ and R₄, together with the linking carbon atom, form a 5- or 6-membered hydrocarbon ring, and the aromatic radicals of the linking group Y are unsubstituted or substituted by halogen or C₁-C₄-alkyl,
X is -S-, -O-, or -SO₂-, and
n is an integer from 0 to 300, in particular from 0 to 30.

8. Use of an epoxy acrylate of formula II according to claim 1 as acrylate component in photoresist formulations.

9. Use of an epoxy acrylate of formula III according to claim 6 as acrylate component in photoresist formulations.

## Revendications

1. Epoxyacrylates de formule II 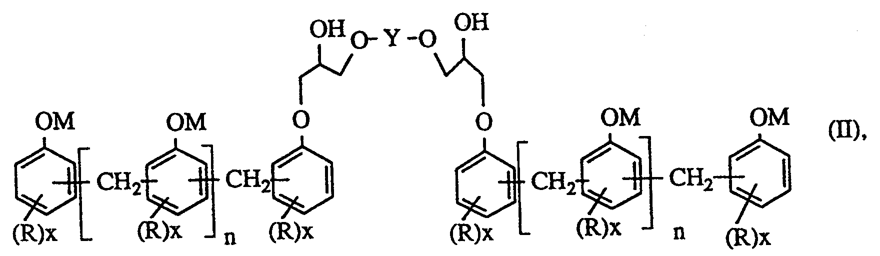 où
M représente le groupe de formule 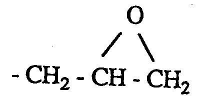 ou 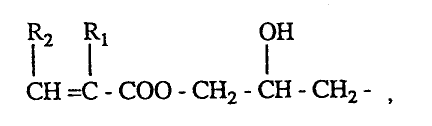 R₁ représente -H ou CH₃, R₂ représente -H, CH₃ ou un groupe phényle,
R représente un groupe alkyle en C₁-C₄ ou un atome d'halogène, de préférence CH₃ ou Br,
x est un nombre entier de 0 à 3, de préférence 0 ou 1, et
Y est un élément de pontage de formules 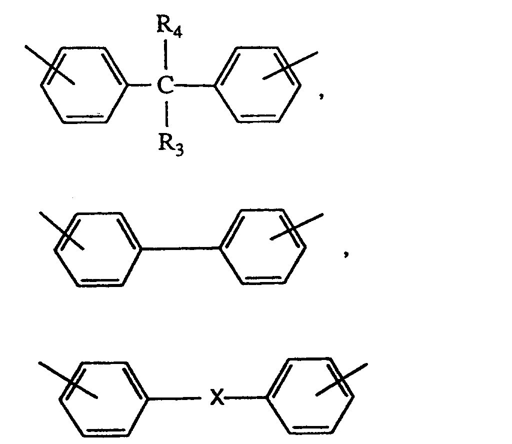 ou 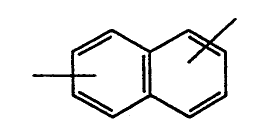 où
R₃ et R₄ représentent, indépendamment l'un de l'autre, des atomes d'hydrogène ou des groupes alkyle en C₁-C₄ ou R₃ et R₄ forment, conjointement avec l'atome de carbone auquel ils sont liés, un cycle hydrocarboné de 5 à 6 chaînons, et les restes aromatiques de l'élément de pontage Y sont non substitués ou substitués par un groupe alkyle en C₁-C₄,
X représente -S-, -O- ou -SO₂-, et
n est un nombre entier de 0 à 300, où 10% molaires des restes M présentent la structure de formule 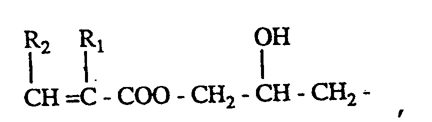 R₁ et R₂ ayant la signification donnée ci-dessus.

2. Epoxyacrylates de formule II selon la revendication 1, où R représente -H ou -CH₃, R₁ représente -H ou -CH₃, R₂ représente -H, x vaut 0 ou 1, n est un nombre entier de 0 à 30 et Y est un élément de pontage de formule 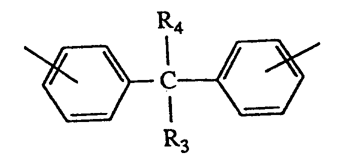 R₃ et R₄ représentent -H ou un groupe alkyle en C₁-C₄ et les restes aromatiques de l'élément de pontage sont non substitués ou substitués par des atomes d'halogènes ou des groupes alkyle en C₁-C₄.

3. Epoxyacrylates de formule II selon la revendication 1, où Y est un élément de pontage de formule

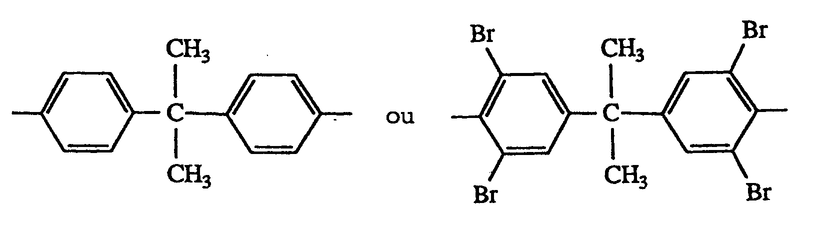

4. Epoxyacrylates de formule II selon la revendication 1, où R représente -H ou -CH₃ et R₂ représente -H.

5. Procédé de préparation des époxyacrylates de formule II selon la revendication 1, caractérisé en ce qu'on fait réagir une époxynovolaque avancée de formule I 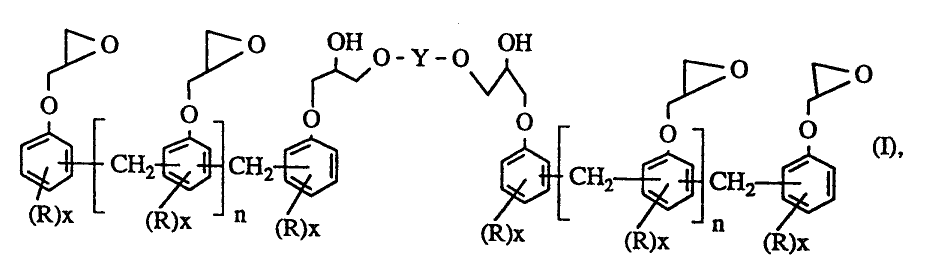 où R, Y, n et x possèdent la signification donnée à la revendication 1, avec un acide monocarboxylique à insaturation éthylénique, éventuellement en présence d'un catalyseur et d'un inhibiteur de polymérisation, à température élevée.

6. Epoxyacrylates contenant des groupes carboxyle de formule III 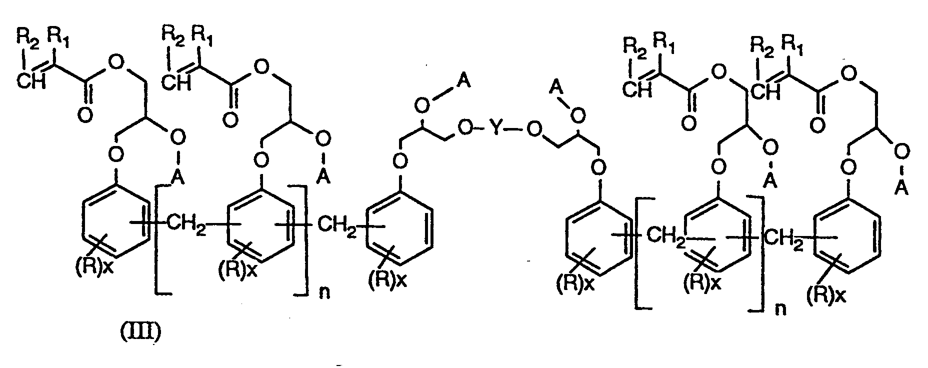 où
A représente un atome d'hydrogène ou le groupe de formule 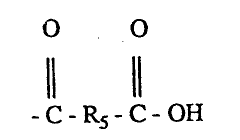 et
R₁, R₂, R, n et x possèdent la signification donnée à la revendication 1,
R₅ représente le reste d'un anhydride cyclique d'un acide polycarboxylique après avoir éliminé le reste anhydride, et au moins 10% molaires du reste A présentent la structure de formule ci-dessus 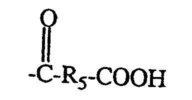 et
y est un élément de pontage de formules 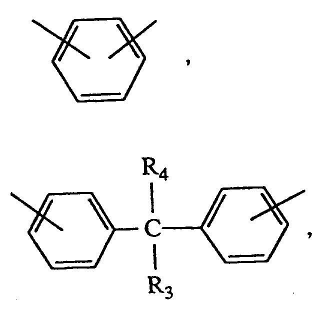 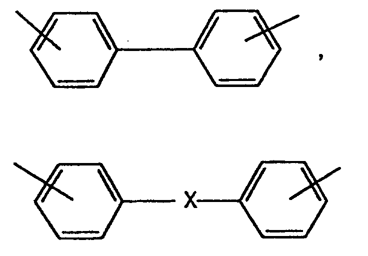 ou 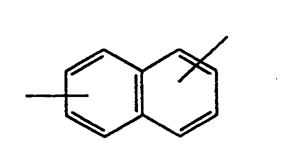 où
R₃ et R₄ représentent, indépendamment l'un de l'autre, des atomes d'hydrogène ou des groupes alkyle en C₁-C₄, ou R₃ et R₄ forment, conjointement avec l'atome de carbone auquel ils sont liés, un cycle hydrocarboné de 5 à 6 chaînons, et les restes aromatiques de l'élément de pontage Y sont non substitués ou substitués par des atomes d'halogènes ou des groupes alkyle en C₁-C₄,
X représente -S-, -O- ou -SO₂-.

7. Procédé de préparation des époxyacrylates contenant des groupes carboxyle de formule III selon la revendication 6, caractérisé en ce qu'on fait réagir un époxyacrylate de formule IIa avec un anhydride cyclique d'un acide polycarboxylique, éventuellement en présence d'un catalyseur et d'un inhibiteur de polymérisation, à température élevée :
Formule IIa : 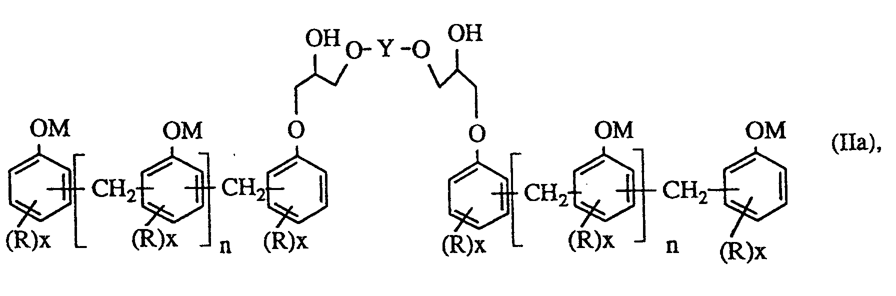 où
M représente le groupe de formule 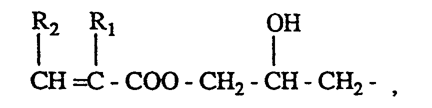 R₁ représente -H ou CH₃, R₂ représente -H, CH₃ ou phényle,
R représente un groupe alkyle en C₁-C₄ ou un atome d'halogène, de préférence CH₃ ou Br,
x est un nombre entier de 0 à 3, de préférence 0 ou 1, et
Y est un élément de pontage de formules 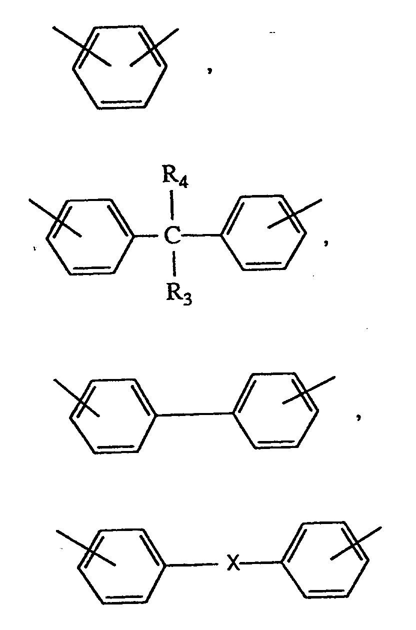 ou 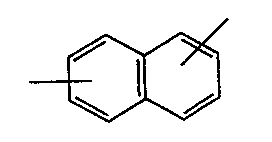 où
R₃ et R₄ représentent, indépendamment l'un de l'autre, des atomes d'hydrogène ou des groupes alkyle en C₁-C₄, ou R₃ et R₄ forment, conjointement avec l'atome de carbone auquel ils sont liés, un cycle hydrocarboné de 5 à 6 chaînons, et les restes aromatiques de l'élément de pontage Y sont non substitués ou substitués par des atomes d'halogènes ou des groupes alkyle en C₁-C₄,
X représente -S-, -O- ou -SO₂-, et
n est un nombre entier de 0 à 300, en particulier de 0 à 30.

8. Utilisation des époxyacrylates de formule II selon la revendication 1 en tant que constituant acrylique dans des formulations de résists.

9. Utilisation des époxyacrylates de formule III selon la revendication 6 en tant que constituant acrylate dans des formulation de résists.
